# EUROPEAN PATENT APPLICATION

(11) **EP 4 700 464 A1**
(43) Date of publication of application: **25.02.2026**
(21) Application number: 24813983.4
(22) Date of filing: 17.04.2024
(51) Int. Cl.: G02F 1/1343, G02F 1/1345

(54) **ARRAY SUBSTRATE, DISPLAY PANEL AND DISPLAY APPARATUS**

(30) Priority: 30.05.2023 CN 202310621553
(71) Applicant: Boe Technology Group Co., Ltd., Beijing 100015 (CN); Beijing BOE Display Technology Co., Ltd., Beijing 100176 (CN)
(72) Inventor: QIN, Wei, Beijing 100176 (CN); NIE, Lujie, Beijing 100176 (CN); MIAO, Yingmeng, Beijing 100176 (CN); YANG, Yue, Beijing 100176 (CN)
(74) Representative: Cohausz & Florack
(86) International application number: PCT/CN2024/088352
(87) International publication number: WO 2024/244777

(57) **Abstract**

An array substrate, a display panel and a display apparatus. The array substrate comprises common wiring (5), comprising a first common wiring portion (51) and a second common wiring portion (52) which are distributed in sequence along a first direction (X); the first common wiring portion (51) extends along the first direction (X), and an orthographic projection of the first common wiring portion (51) onto the substrate (1) and an orthographic projection of a pixel electrode (4) onto the substrate (1) have an overlapping region; the second common wiring portion (52) extends along a second direction (Y), and an orthographic projection of the second common wiring portion (52) onto the substrate (1) is located at the periphery of a data line (3) between adjacent pixel electrodes (4); furthermore, the orthographic projection of the second common wiring portion (52) onto the substrate (1) and an orthographic projection of the pixel electrode (4) onto the substrate (1) have an overlapping region.

## Description

### CROSS-REFERENCE TO RELATED APPLICATIONS

The application claims the priority of the Chinese patent application No. 202310621553.8, filed with the China National Intellectual Property Administration on May 30, 2023 and named "ARRAY SUBSTRATE, DISPLAY PANEL AND DISPLAY APPARATUS", the entire content of which is incorporated herein by reference.

### Technical Field

The present disclosure relates to the field of semiconductor technology, in particular to an array substrate, a display panel and a display apparatus.

### Background

Compared with a conventional pixel driving structure with one gate line and one data line (1G1D), special pixel driving structures are sometimes adopted to reduce the number of data lines and increase the number of scan lines. Such special pixel driving structures are a dual gate pixel driving structure (Dual Gate) and a triple gate pixel driving structure (Triple Gate). In display panels of the same size, compared with the 1G1D pixel driving structure, the number of row scan lines in the triple gate pixel driving structure increases twice, while the number of data lines becomes one-third of the original. If the gate on array (GOA) driving structure is used, an increase in the number of scan lines does not require additional costs for the driving circuit, and a decrease in the number of data lines can reduce the number of driving integrated circuits (ICs), thus having a cost advantage.

### Summary

Embodiments of the present disclosure provide an array substrate, a display panel and a display apparatus. The array substrate includes: a base substrate; a plurality of gate lines, arranged on a side of the base substrate, where the plurality of gate lines extend along a first direction; a plurality of data lines, arranged on the same side of the base substrate as the plurality of gate lines, where the plurality of data lines extend along a second direction; a plurality of pixel electrodes, arranged on the same side of the base substrate as the plurality of gate lines and located in regions formed by intersections of the plurality of gate lines and the plurality of data lines; where the pixel electrode includes a first edge extending along the first direction and a second edge extending along the second direction, and a length of the first edge in the first direction is greater than a length of the second edge in the second direction; and a common routing line, arranged on the same side of the base substrate as the plurality of gate lines, where the common routing line includes: a first common routing part and a second common routing part that are distributed in sequence along the first direction; where the first common routing part extends along the first direction, and an orthographic projection of the first common routing part on the base substrate has an overlapping region with an orthographic projection of the pixel electrode on the base substrate; the second common routing part extends along the second direction, an orthographic projection of the second common routing part on the base substrate is disposed in a periphery of a data line between adjacent pixel electrodes, and the orthographic projection of the second common routing part on the base substrate has an overlapping region with the orthographic projection of the pixel electrode on the base substrate.

In a possible implementation mode, the common routing parts include two second common routing parts, and a third common routing part that connects ends of two second common routing parts and extends along the first direction. The data line includes: a first data part and a second data part that are alternately distributed along the second direction; where, an orthographic projection of the first data part on the base substrate is disposed between two adjacent pixel electrodes; and the third common routing part and the second data part are insulated and crossed.

In a possible implementation mode, the common routing line and the plurality of gate lines are on a same layer; the array substrate further includes: a lapping electrode; the common routing line further includes: a fourth common routing part connected to an end, away from the third common routing part, of the second common routing part; in the second direction, the third common routing part and the fourth common routing part that are adjacent are electrically connected through the lapping electrode.

In a possible implementation mode, an orthographic projection of an extension line of an outer edge of the first data part that is parallel to the second direction on the base substrate has an overlapping region with the lapping electrode.

In a possible implementation mode, the array substrate further includes: a plurality of transistors, and the pixel electrode is electrically connected to the gate line and the data line through the transistor. An orthographic projection of the lapping electrode on the base substrate and an orthographic projection of the transistor on the base substrate are respectively disposed on different sides of the data line.

In a possible implementation mode, two adjacent lapping electrodes along the second direction are respectively disposed on different sides of the data line; and the lapping electrode and the pixel electrode are disposed on a same layer.

In a possible implementation mode, the first common routing part extends along the first direction and passes through a central region of the orthographic projection of the pixel electrode on the base substrate.

In a possible implementation mode, the orthographic projection of the first common routing part on the base substrate overlaps with an orthographic projection of an edge region where the first edge of the pixel electrode is located on the base substrate, and the first common routing part and the second common routing part form a U-shaped pattern with one side opening.

In a possible implementation mode, a direction of an opening of a pattern enclosed by two second common routing parts and the third common routing part are the same as a direction of an opening of a pattern enclosed by the first common routing part and second common routing parts on both sides of the first common routing part.

In a possible implementation mode, the pixel electrode has a first side opposite to the gate line on one side and a second side opposite to the gate line on the other side; the first side and an opening of the first common routing part are on a same side; a minimum distance between the first side of the pixel electrode and an adjacent gate line is smaller than a minimum distance between the second side and an adjacent gate line.

In a possible implementation mode, the orthographic projection of the first common routing part on the base substrate overlaps with orthographic projections of edge regions where two first edges of the pixel electrode are located on the base substrate, and the first common routing part and the second common routing part form a closed ring-shaped pattern.

In a possible implementation mode, the pixel electrode includes: a plurality of sub-pixel electrode parts distributed in sequence along the first direction; and the sub-pixel electrode part has a first slit structure.

In a possible implementation mode, the plurality of sub-pixel electrode parts include: a first sub-pixel electrode part, a second sub-pixel electrode part, a third sub-pixel electrode part, and a fourth sub-pixel electrode part that are distributed in sequence along the first direction; an extension direction of a first slit structure of the first sub-pixel electrode part is the same as an extension direction of a first slit structure of the third sub-pixel electrode part; an extension direction of a first slit structure of the second sub-pixel electrode part is the same as an extension direction of a first slit structure of the fourth sub-pixel electrode part.

In a possible implementation mode, the pixel electrode further includes: a second slit structure that is disposed between adjacent sub-pixel electrode parts and extends along the second direction.

In a possible implementation mode, the orthographic projection of the pixel electrode on the base substrate at least covers an orthographic projection of part of the gate line on the base substrate.

In a possible implementation mode, the display substrate further includes: an organic insulating layer disposed between the data line and the pixel electrode.

In a possible implementation mode, a width of the first data part in the first direction is greater than a width of the second data part in the first direction.

In a possible implementation mode, the plurality of pixel electrodes include: a plurality of pixel rows extending along the first direction and arranged in sequence along the second direction, and a plurality of pixel columns arranged in sequence along the second direction and along the first direction; the plurality of pixel electrodes include: a first type of pixel electrode that emits light of a first color, a second type of pixel electrode that emits light of a second color, and a third type of pixel electrode that emits light of a third color; in the same pixel row, the first type of pixel electrode, the second type of pixel electrode, and the third type of pixel electrode are distributed in sequence; in the same pixel column, only one of the first type of pixel electrode, the second type of pixel electrode, or the third type of pixel electrode is distributed; in the same pixel row, each of the plurality of pixel electrodes is electrically connected to a same gate line through a transistor; in the same pixel column, two adjacent pixel electrodes are alternately electrically connected to different data lines on both sides of the pixel electrodes through transistors.

Embodiments of the present disclosure further provide a display panel, including the array substrate according to the embodiments of the present disclosure, and an opposite substrate opposite to the array substrate. The opposite substrate is provided with a common electrode layer, and a signal loaded on the common routing line is the same as a signal loaded on the common electrode layer.

In a possible implementation mode, the opposite substrate is further provided with a spacer, and an orthographic projection of a first data part on the base substrate covers an orthographic projection of the spacer on the base substrate.

In a possible implementation mode, the opposite substrate is also provided with a spacer, an orthographic projection of the spacer on the base substrate is disposed on a side of an orthographic projection of a second data part on the base substrate, and the orthographic projection of the spacer on the base substrate has an overlapping region with an orthographic projection of a lapping electrode on the base substrate.

In a possible implementation mode, the orthographic projection of the spacer on the base substrate and an orthographic projection of a transistor on the base substrate are respectively disposed on different sides of the data line.

In a possible implementation mode, at least one of the array substrate or the opposite substrate is provided with an alignment film layer, the alignment film layer includes a pixel alignment region corresponding to the pixel electrode, the pixel alignment region includes four sub-alignment regions, and alignment directions of at least two of the sub-alignment regions are different.

Embodiments of the present disclosure further provide a display apparatus, including the display panel according to the embodiments of the present disclosure.

### Brief Description of Figures

FIG. 1 is an equivalent circuit diagram of a display panel with a driving architecture having a triple gate pixel driving structure according to the embodiments of the present disclosure.
FIG. 2A is one of top view schematic diagrams of a display panel according to the embodiments of the present disclosure.
FIG. 2B is a schematic diagram of a single film layer where gate lines are located in FIG. 2A.
FIG. 2C is a schematic diagram of a single film layer where an active layer is located in FIG. 2A.
FIG. 2D is a schematic diagram of a single film layer where data lines are located in FIG. 2A.
FIG. 2E is a schematic diagram of a single film layer where a first insulating layer is located in FIG. 2A.
FIG. 2F is a schematic diagram of a single film layer where pixel electrodes are located in FIG. 2A.
FIG. 2G is a schematic diagram of a single film layer where spacers are located in FIG. 2A.
FIG. 2H is a schematic diagram of a single film layer where a black matrix is located in FIG. 2A.
FIG. 2I is a cross-sectional schematic diagram at AA' in FIG. 2A.
FIG. 2J is a cross-sectional schematic diagram at BB' in FIG. 2A.
FIG. 2K is a schematic diagram of a light effect simulation result at one of the sub-pixels in FIG. 2A.
FIG. 2L is an alignment part corresponding to one of the pixel electrodes 4 in FIG. 2A.
FIG. 3A is one of top view schematic diagrams of a display panel according to the embodiments of the present disclosure.
FIG. 3B is a schematic diagram of a single film layer where gate lines are located in FIG. 3A.
FIG. 3C is a schematic diagram of a single film layer where an active layer is located in FIG. 3A.
FIG. 3D is a schematic diagram of a single film layer where data lines are located in FIG. 3A.
FIG. 3E is a schematic diagram of a single film layer where a first insulating layer is located in FIG. 3A.
FIG. 3F is a schematic diagram of a single film layer where pixel electrodes are located in FIG. 3A.
FIG. 3G is a schematic diagram of a single film layer where spacers are located in FIG. 3A.
FIG. 3H is a schematic diagram of a single film layer where a black matrix is located in FIG. 3A.
FIG. 3I is a cross-sectional schematic diagram at AA' in FIG. 3A.
FIG. 3J is a cross-sectional schematic diagram at BB' in FIG. 3A.
FIG. 3K is a schematic diagram of a light effect simulation result at one of the sub-pixels in FIG. 3A.
FIG. 4A is one of top view schematic diagrams of a display panel according to the embodiments of the present disclosure.
FIG. 4B is a schematic diagram of a single film layer where gate lines are located in FIG. 4A.
FIG. 4C is a schematic diagram of a single film layer where an active layer is located in FIG. 4A.
FIG. 4D is a schematic diagram of a single film layer where data lines are located in FIG. 4A.
FIG. 4E is a schematic diagram of a single film layer where a first insulating layer is located in FIG. 4A.
FIG. 4F is a schematic diagram of a single film layer where pixel electrodes are located in FIG. 4A.
FIG. 4G is a schematic diagram of a single film layer where spacers are located in FIG. 4A.
FIG. 4H is a schematic diagram of a single film layer where a black matrix is located in FIG. 4A.
FIG. 4I is a cross-sectional schematic diagram at AA' in FIG. 4A.
FIG. 4J is a cross-sectional schematic diagram at BB' in FIG. 4A.
FIG. 4K is a schematic diagram of a light effect simulation result at one of the sub-pixels in FIG. 4A.
FIG. 5A is one of top view schematic diagrams of a display panel according to the embodiments of the present disclosure.
FIG. 5B is a schematic diagram of a single film layer where gate lines are located in FIG. 5A.
FIG. 5C is a schematic diagram of a single film layer where an active layer is located in FIG. 5A.
FIG. 5D is a schematic diagram of a single film layer where data lines are located in FIG. 5A.
FIG. 5E is a schematic diagram of a single film layer where a first insulating layer is located in FIG. 5A.
FIG. 5F is a schematic diagram of a single film layer where pixel electrodes are located in FIG. 5A.
FIG. 5G is a schematic diagram of a single film layer where spacers are located in FIG. 5A.
FIG. 5H is a schematic diagram of a single film layer where a black matrix is located in FIG. 5A.
FIG. 6 is a schematic diagram of an equivalent pixel circuit diagram according to the embodiments of the present disclosure.

### Detailed Description

In order to make the objectives, technical solutions, and advantages of embodiments of the present disclosure clearer, technical solutions of the embodiments of the present disclosure will be clearly and completely described below in conjunction with accompanying drawings of the embodiments of the present disclosure. Obviously, the described embodiments are only a part of the embodiments of the present disclosure, rather than all of them. Based on the described embodiments of the present disclosure, all other embodiments obtained by those of ordinary skill in the art without creative efforts fall within the protection scope of the present disclosure.

Unless otherwise defined, technical terms or scientific terms used in the present disclosure shall have the ordinary meanings understood by those with general skills in the field to which the present disclosure belongs. The terms such as "first" and "second" used in the present disclosure do not indicate any order, quantity, or importance, but are only used to distinguish different components. Terms like "comprise" or "include" mean that the elements or items preceding the word cover the elements or items listed after the word and their equivalents, without excluding other elements or items. Terms like "connect" or "couple" are not limited to physical or mechanical connections, but may also include electrical connections, whether direct or indirect. Words like "upper", "lower", "left", and "right" are only used to indicate relative positional relationships, and when the absolute position of the described object changes, the relative positional relationship may also change accordingly.

As used herein, "approximately" or "substantially the same" includes the stated value and means within an acceptable deviation range for a specific value as determined by those of ordinary skill in the art considering the measurement as discussed and errors related to the measurement of specific quantities (i.e., the limitations of the measurement system). For example, "substantially the same" may mean that a difference relative to the stated value is within one or more standard deviation ranges, or within the range of ±30%, 20%, 10%, or 5%.

In the accompanying drawings, for the sake of clarity, thicknesses of layers, films, panels, regions, etc., are enlarged. Exemplary embodiments are described herein with reference to cross-sectional views that are schematic diagrams of idealized implementation modes. Thus, deviations from shapes in the figures as a result of, for example, manufacturing techniques and/or tolerances are expected. Therefore, the embodiments described herein should not be construed as being limited to specific shapes of regions as shown herein, but rather include deviations in shape caused by, for example, manufacturing. For example, a region illustrated or described as flat may typically have rough and/or non-linear features. Moreover, the illustrated sharp corners may be rounded. Thus, regions shown in the figures are schematic in nature, and their shapes are not intended to illustrate exact shapes of the regions and are not intended to limit the scope of claims.

In order to keep the following description of embodiments of the present disclosure clear and concise, the present disclosure omits the detailed descriptions of known functions and known components.

Compared with the 1G1D structure, a pixel aperture ratio and transmittance of the triple gate pixel driving structure are reduced, which affects the light efficiency performance of the display panel.

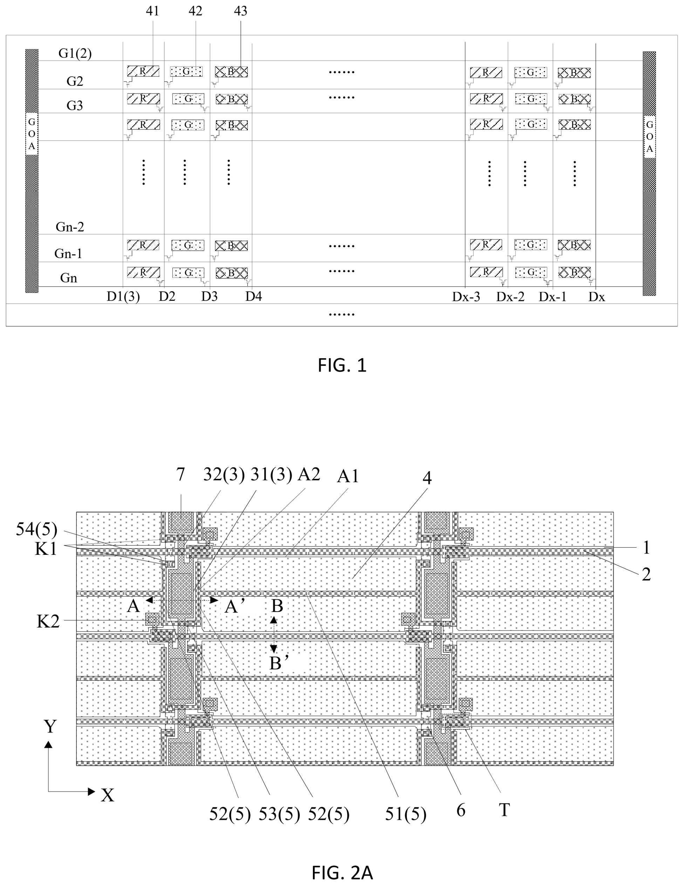

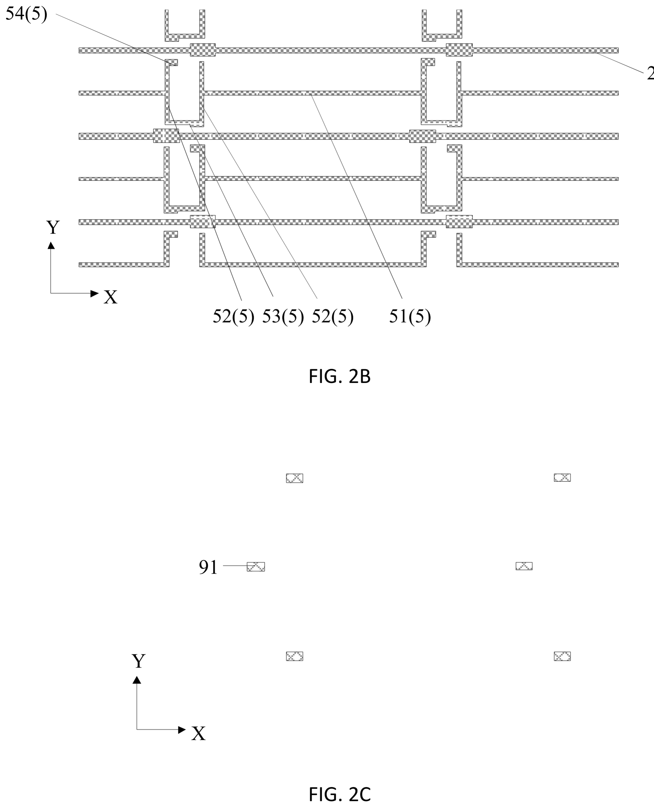

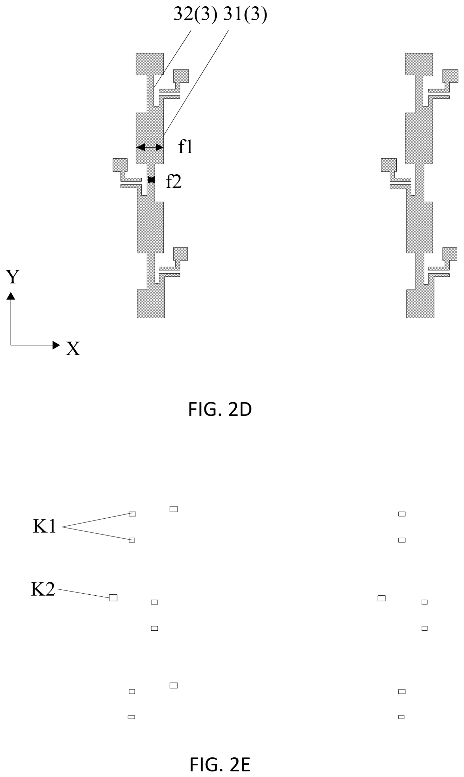

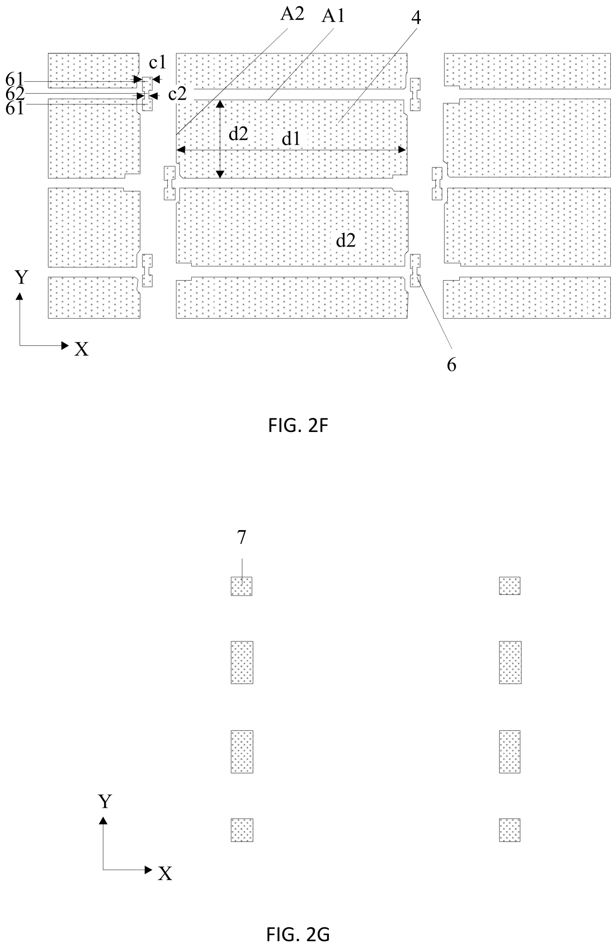

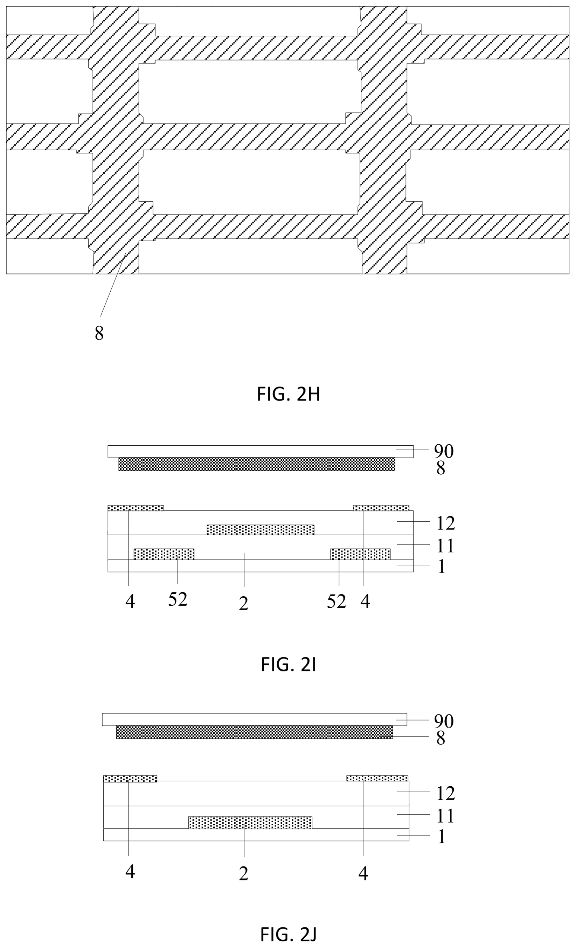

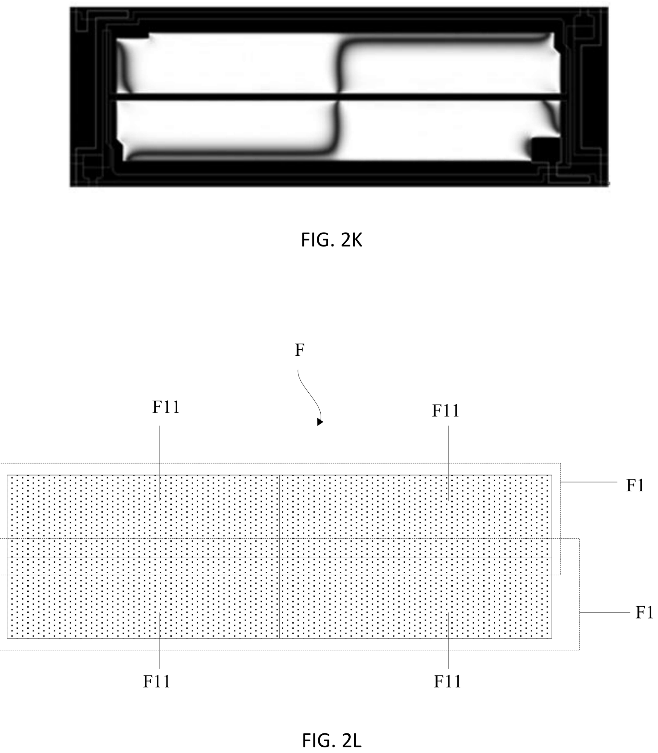

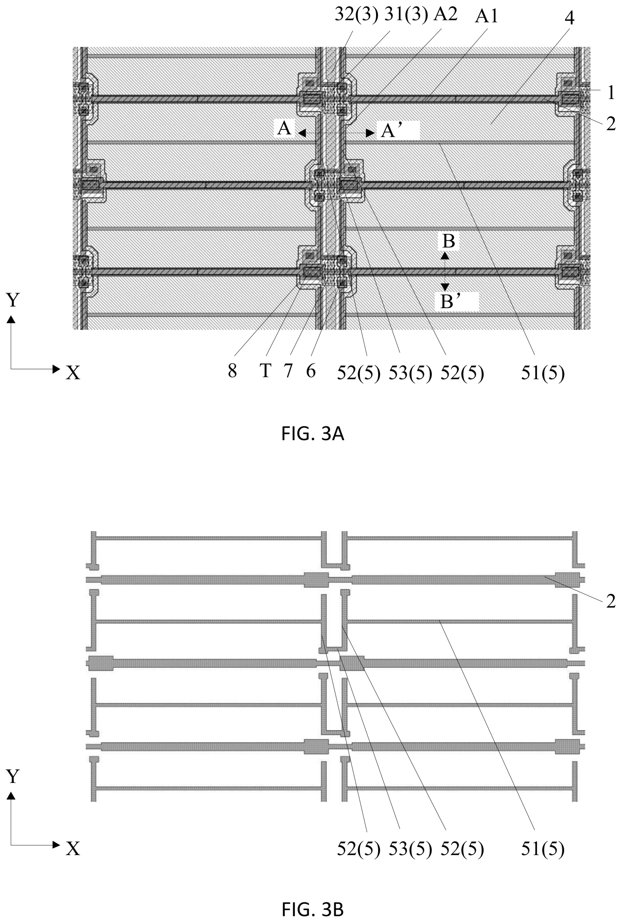

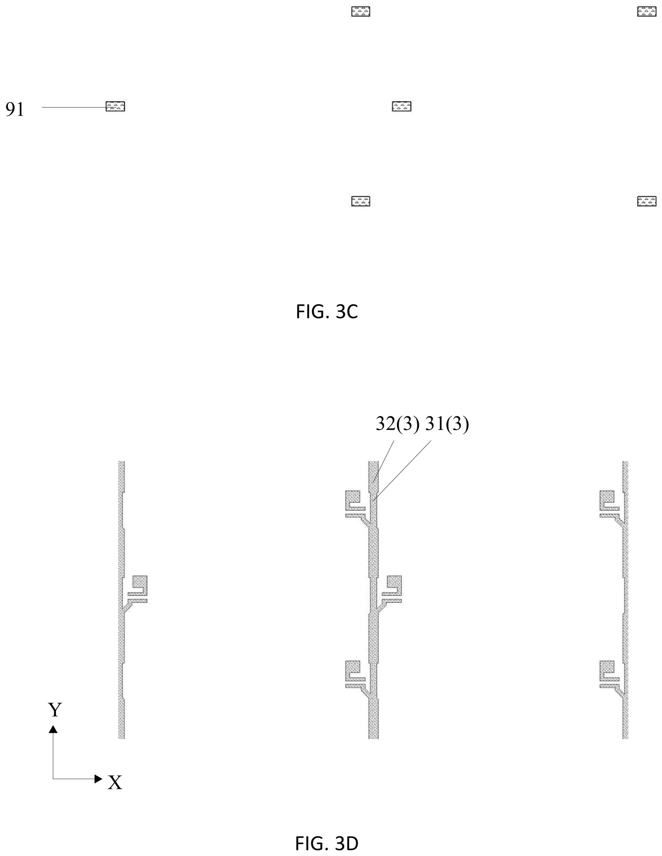

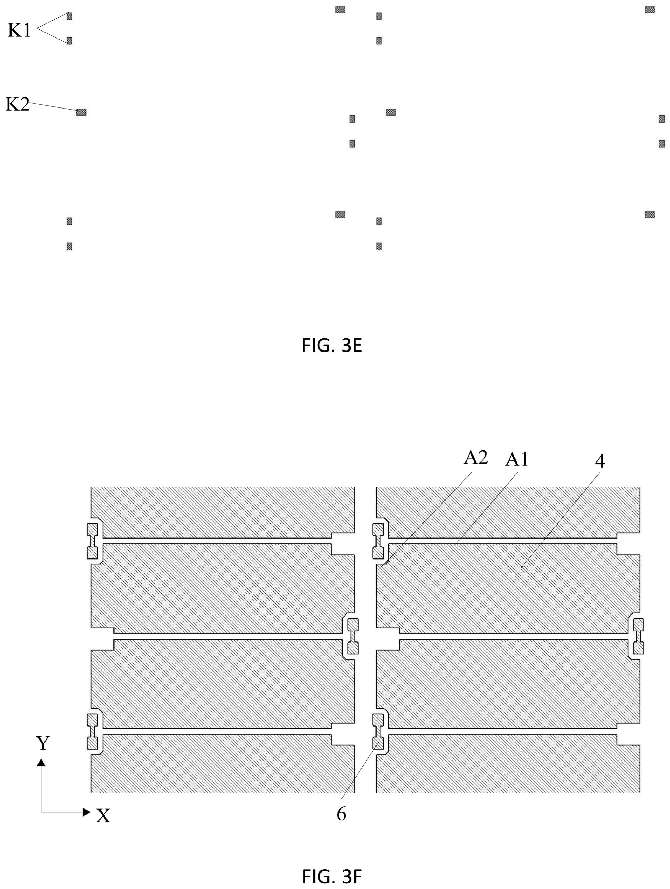

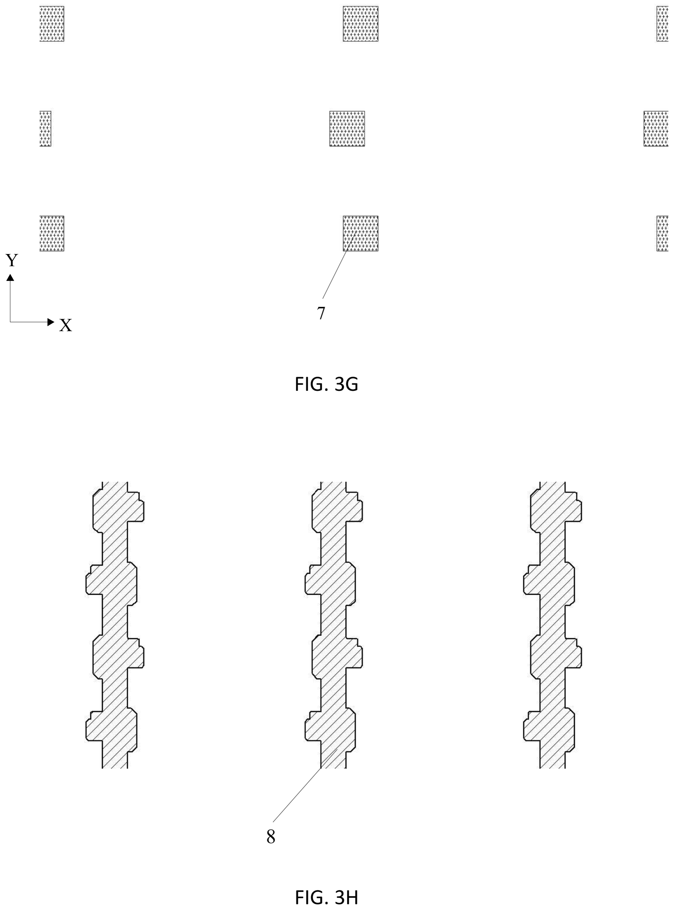

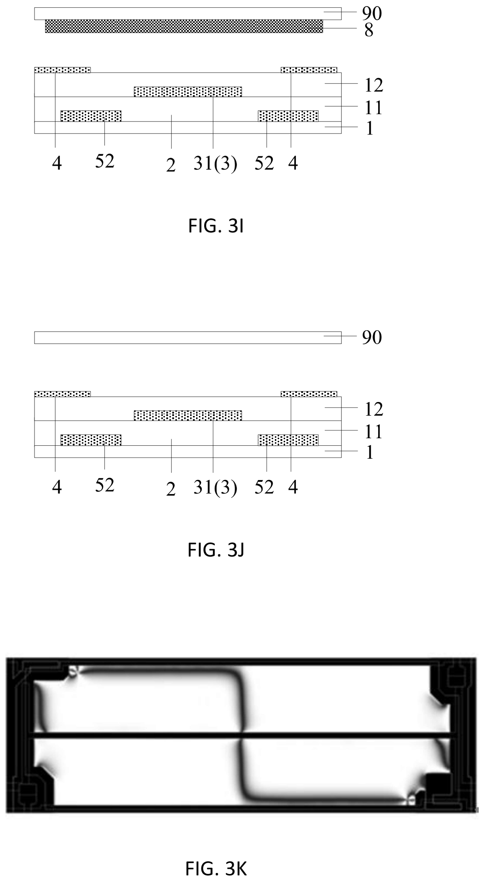

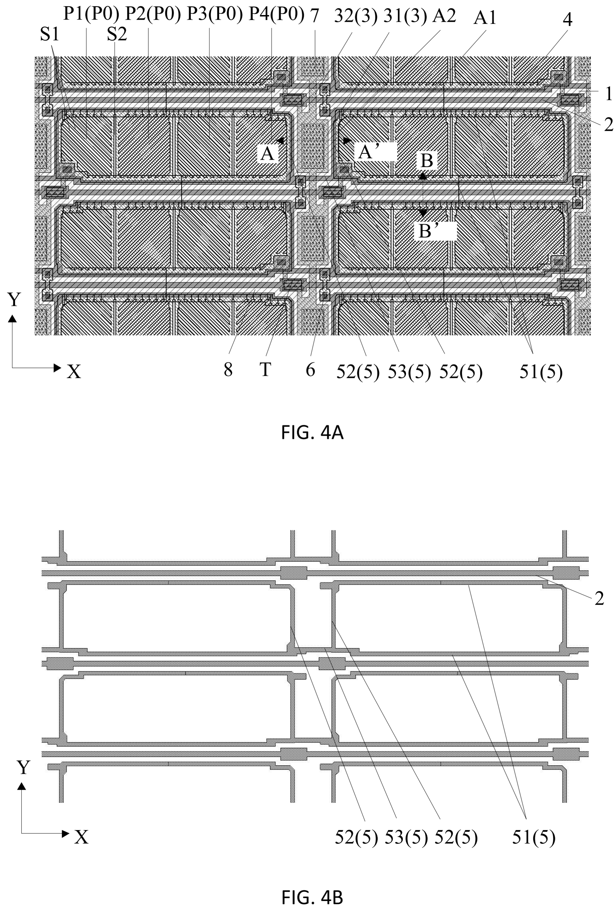

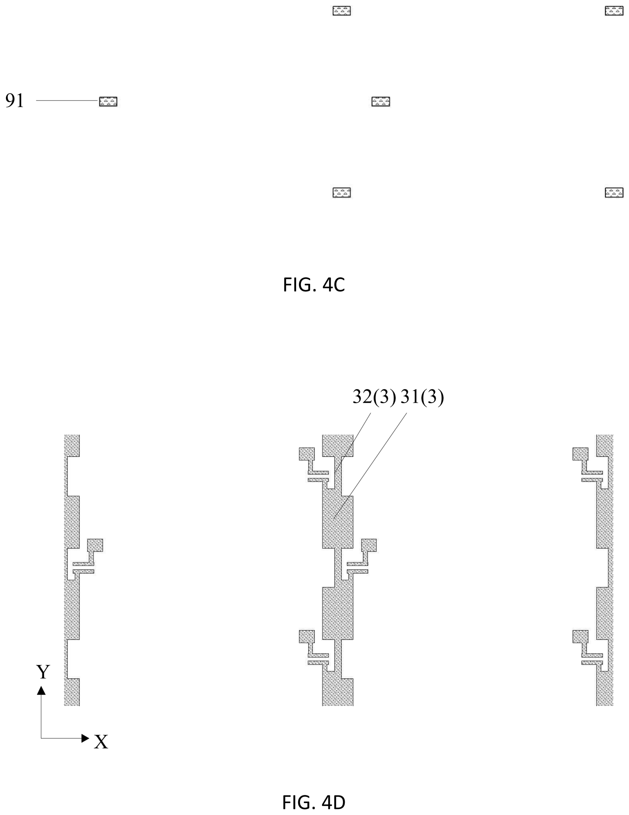

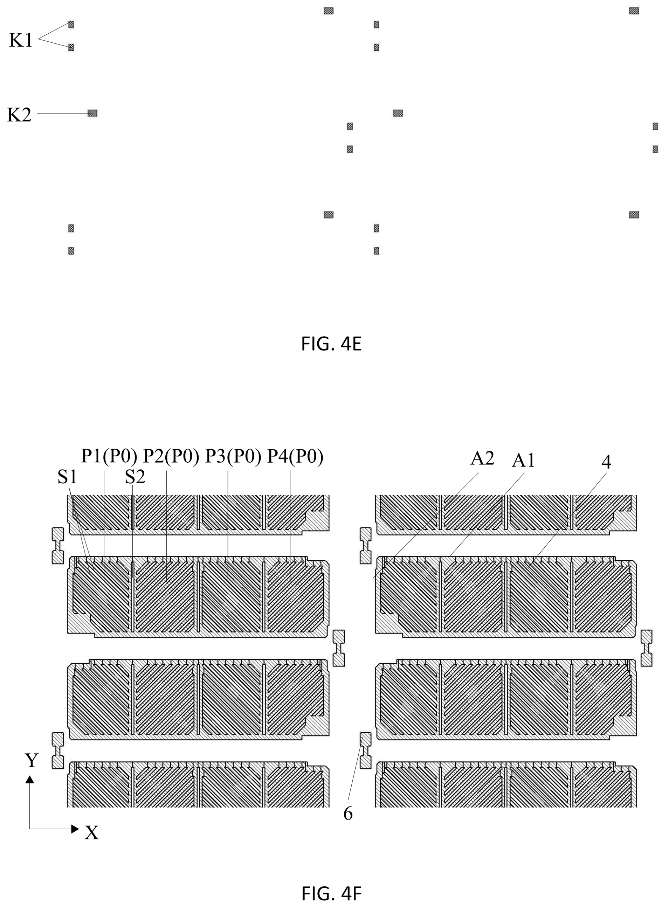

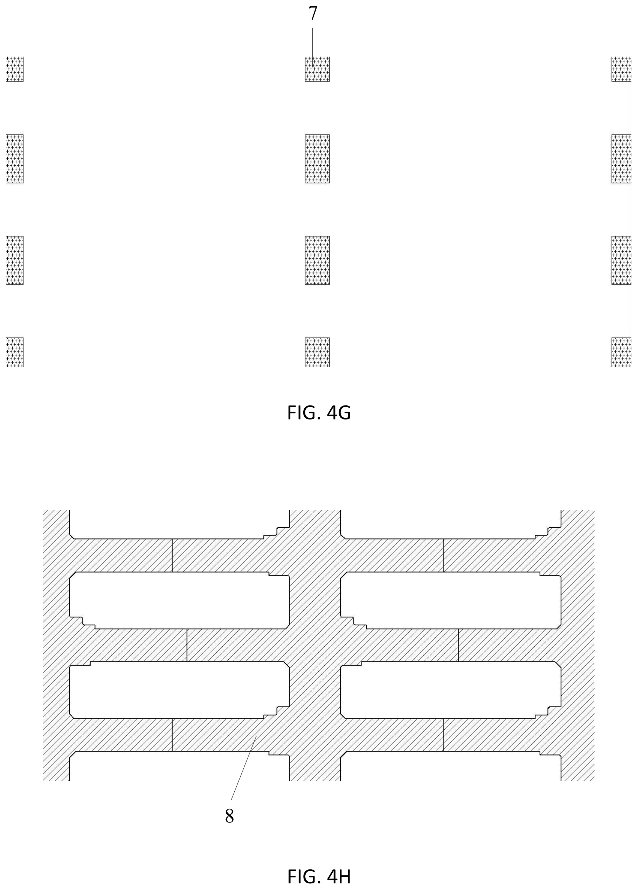

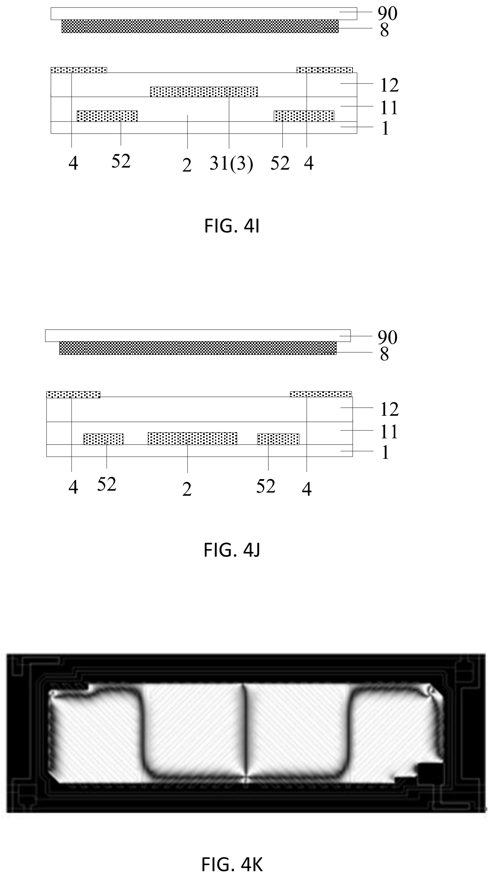

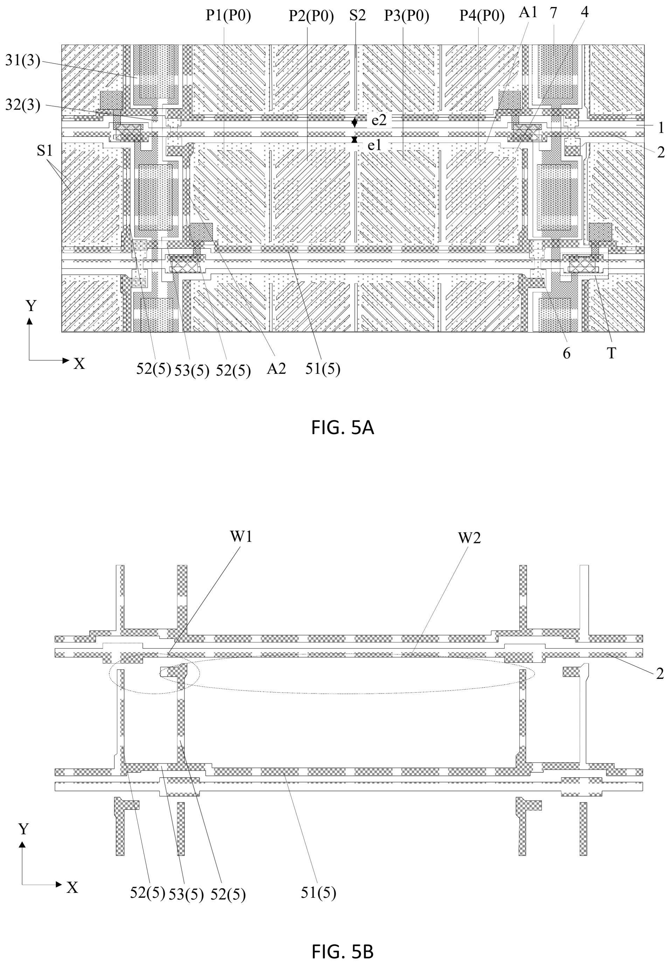

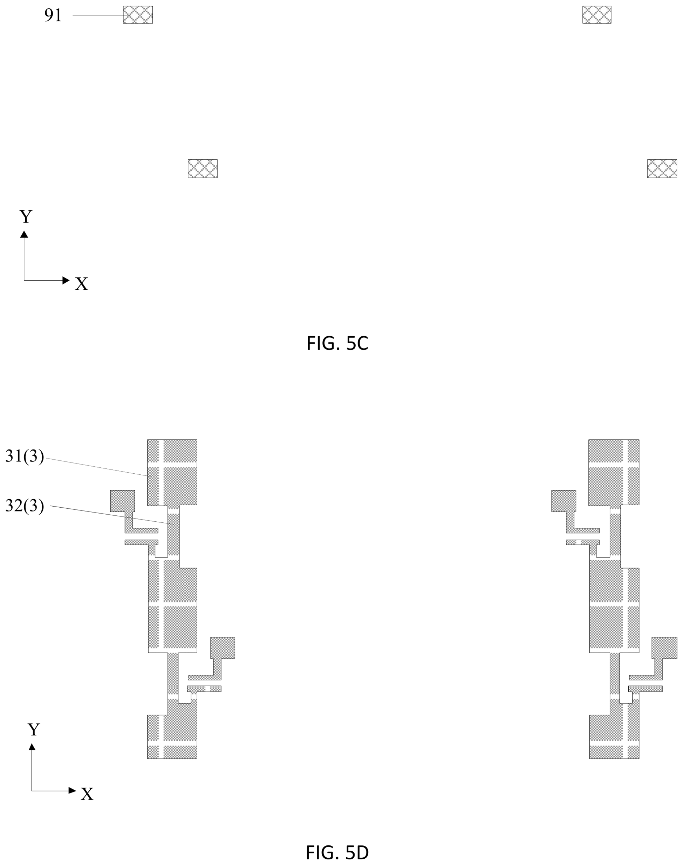

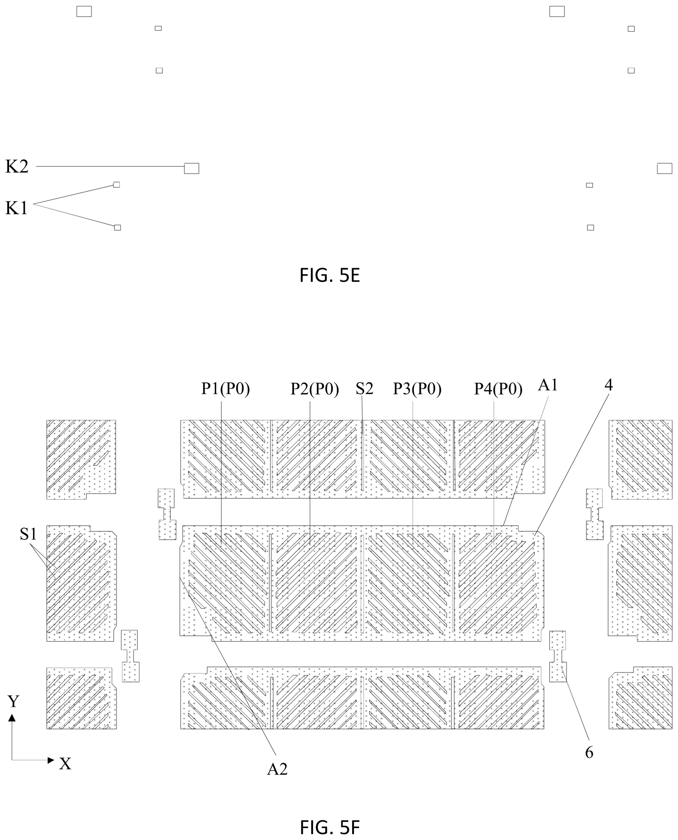

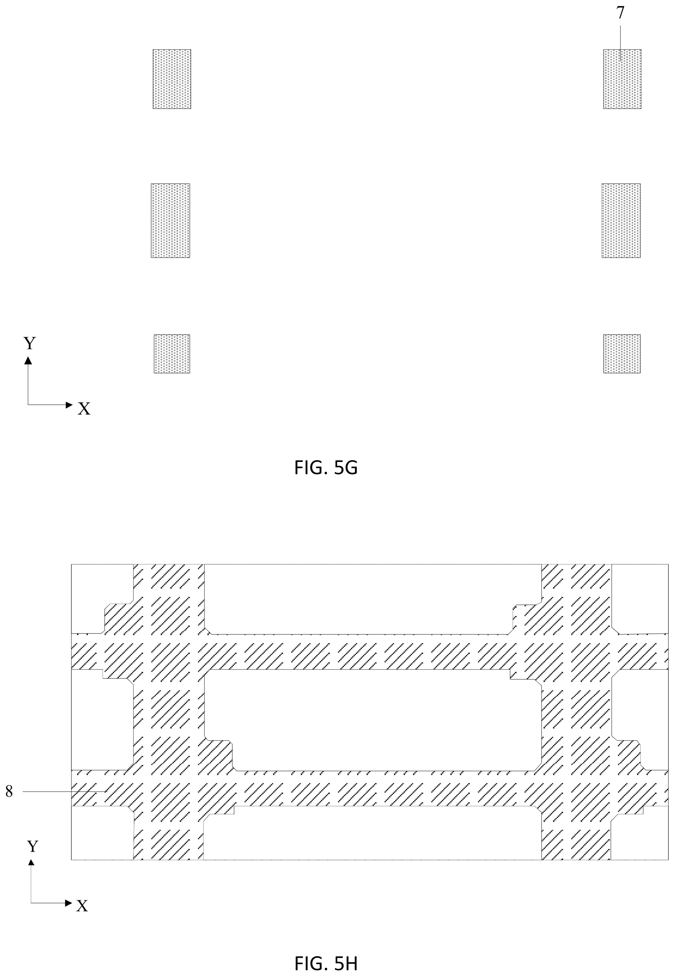

Referring to FIG. 1, FIGS. 2A - 2K, FIGS. 3A - 3K, FIGS. 4A - 4K and FIGS. 5A - 5H, FIG. 2A is one of top view schematic diagrams of a display panel according to embodiments of the present disclosure, FIG. 2B is a schematic diagram of a single film layer where gate lines are located in FIG. 2A, FIG. 2C is a schematic diagram of a single film layer where an active layer is located in FIG. 2A, FIG. 2D is a schematic diagram of a single film layer where data lines are located in FIG. 2A, FIG. 2E is a schematic diagram of a single film layer where a first insulating layer is located in FIG. 2A, FIG. 2F is a schematic diagram of a single film layer where pixel electrodes are located in FIG. 2A, FIG. 2G is a schematic diagram of a single film layer where spacers are located in FIG. 2A, FIG. 2H is a schematic diagram of a single film layer where a black matrix is located in FIG. 2A, FIG. 2I is a cross-sectional schematic diagram at AA' in FIG. 2A, FIG. 2J is a cross-sectional schematic diagram at BB' in FIG. 2A, FIG. 2K is a schematic diagram of a light effect simulation result at one of the sub-pixels in FIG. 2A, FIG. 3A is one of top view schematic diagrams of a display panel according to embodiments of the present disclosure, FIG. 3B is a schematic diagram of a single film layer where gate lines are located in FIG. 3A, FIG. 3C is a schematic diagram of a single film layer where an active layer is located in FIG. 3A, FIG. 3D is a schematic diagram of a single film layer where data lines are located in FIG. 3A, FIG. 3E is a schematic diagram of a single film layer where a first insulating layer is located in FIG. 3A, FIG. 3F is a schematic diagram of a single film layer where pixel electrodes are located in FIG. 3A, FIG. 3G is a schematic diagram of a single film layer where spacers are located in FIG. 3A, FIG. 3H is a schematic diagram of a single film layer where a black matrix is located in FIG. 3A, FIG. 3I is a cross-sectional schematic diagram at AA' in FIG. 3A, FIG. 3J is a cross-sectional schematic diagram at BB' in FIG. 3A, FIG. 3K is a schematic diagram of a light effect simulation result at one of the sub-pixels in FIG. 3A, FIG. 4A is one of top view schematic diagrams of a display panel according to embodiments of the present disclosure, FIG. 4B is a schematic diagram of a single film layer where gate lines are located in FIG. 4A, FIG. 4C is a schematic diagram of a single film layer where an active layer is located in FIG. 4A, FIG. 4D is a schematic diagram of a single film layer where data lines are located in FIG. 4A, FIG. 4E is a schematic diagram of a single film layer where a first insulating layer is located in FIG. 4A, FIG. 4F is a schematic diagram of a single film layer where pixel electrodes are located in FIG. 4A, FIG. 4G is a schematic diagram of a single film layer where spacers are located in FIG. 4A, FIG. 4H is a schematic diagram of a single film layer where a black matrix is located in FIG. 4A, FIG. 4I is a cross-sectional schematic diagram at AA' in FIG. 4A, FIG. 4J is a cross-sectional schematic diagram at BB' in FIG. 4A, FIG. 4K is a schematic diagram of a light effect simulation result at one of the sub-pixels in FIG. 4A, FIG. 5A is one of top view schematic diagrams of a display panel according to embodiments of the present disclosure, FIG. 5B is a schematic diagram of a single film layer where gate lines are located in FIG. 5A, FIG. 5C is a schematic diagram of a single film layer where an active layer is located in FIG. 5A, FIG. 5D is a schematic diagram of a single film layer where data lines are located in FIG. 5A, FIG. 5E is a schematic diagram of a single film layer where a first insulating layer is located in FIG. 5A, FIG. 5F is a schematic diagram of a single film layer where pixel electrodes are located in FIG. 5A, FIG. 5G is a schematic diagram of a single film layer where spacers are located in FIG. 5A, and FIG. 5H is a schematic diagram of a single film layer where a black matrix is located in FIG. 5A. An array substrate is provided in the embodiments of the present disclosure, including:
a base substrate 1;
a plurality of gate lines 2, located on a side of the base substrate 1, where the plurality of gate lines 2 extend along a first direction X;
a plurality of data lines 3, located on the same side of the base substrate 1 as the plurality of gate lines 2, where the plurality of data lines 3 extend along a second direction Y;
a plurality of pixel electrodes 4, located on the same side of the base substrate 1 as the plurality of gate lines 2 and located in regions formed by intersections of the gate lines 2 and the data lines 3; where the pixel electrode 4 includes a first edge A1 extending along the first direction X and a second edge A2 extending along the second direction Y, and a length of the first edge A1 in the first direction X is greater than a length of the second edge A2 in the second direction Y; for example, as shown in FIG. 2F, the length of the first edge A1 in the first direction X is a1, which is greater than the length a2 of the second edge A2 in the second direction Y, and a1 is greater than a2; and
a common routing line 5, located on the same side of the base substrate 1 as the gate lines 2, and including: a first common routing part 51 and a second common routing part 52 that are distributed in sequence along the first direction X. Herein, the first common routing part 51 extends along the first direction X, and an orthographic projection of the first common routing part 51 on the base substrate 1 has an overlapping region with an orthographic projection of the pixel electrode 4 on the base substrate 1. The second common routing part 52 extends along the second direction Y, an orthographic projection of the second common routing part 52 on the base substrate 1 is disposed in a periphery of the data line 3 between adjacent pixel electrodes 4, and the orthographic projection of the second common routing part 52 on the base substrate 1 has an overlapping region with the orthographic projection of the pixel electrode 4 on the base substrate 1.

In the embodiments of the present disclosure, for the triple gate pixel driving structure, the common routing line 5 includes the first common routing part 51 and the second common routing part 52; where, the first common routing part 51 extends along the first direction X, and the orthographic projection of the first common routing part 51 on the base substrate 1 has an overlapping region with the orthographic projection of the pixel electrode 4 on the base substrate 1; the second common routing part 52 extends along the second direction Y, the orthographic projection of the second common routing part 52 on the base substrate 1 is around the data line 3 between adjacent pixel electrodes 4, and the orthographic projection of the second common routing part 52 on the base substrate 1 has an overlapping region with the orthographic projection of the pixel electrode 4 on the base substrate 1. That is, the common routing lines 5 are arranged in both the region where the pixel electrodes 4 are located and the periphery of the data lines 3. The wiring of the common routing lines 5 is relatively dense, which can make the uniformity of the common voltage at various positions of the display panel better, and can make the voltage loaded on the liquid crystal close to the preset voltage. Since the common routing line 5 and the pixel electrode 4 have an overlapping region, a stable overlapping storage capacitor can be formed between the common routing line 5 and the pixel electrode 4, which has a good potential holding effect for charging the data signal (voltage value) into the pixel electrode of the corresponding pixel and before the next frame row scanning. At the same time, the common electrode lines 5 are arranged on both sides of the data line, which can also play a shielding role and improve a coupling capacitance generated between the pixel electrode 4 and the data line 3.

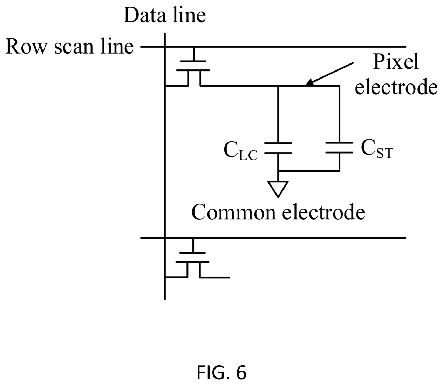

Specifically, FIG. 6 is an equivalent circuit diagram of one of the sub-pixels according to embodiments of the present disclosure. When a row scanning voltage scans to the current row, all the pixel transistors (Pixel TFT) in the current row are turned on, and the data line charges the capacitors C_{LC} and C_{ST} (the stable overlapping capacitor formed by the common routing line 5 and the pixel electrode 4) through the turned-on pixel TFT according to the instruction from the front-end integrated circuit (IC), charging the data (voltage value) into the pixel electrode of the corresponding pixel and maintaining this potential before the next frame row scanning arrives.

In a possible implementation mode, referring to FIGS. 2A - 2K, FIGS. 3A - 3K, FIGS. 4A - 4K and FIGS. 5A - 5H, the common routing parts 5 include two second common routing parts 52; the common routing parts 5 also include: a third common routing part 53 that connects ends of two second common routing parts 52 and extends along the first direction X. The data line 3 includes: a first data part 31 and a second data part 32 that are alternately distributed along the second direction X; where, an orthographic projection of the first data part 31 on the base substrate 1 is located between two adjacent pixel electrodes 4; and the third common routing part 53 and the second data part 32 are insulated and crossed. Specifically, two second common routing parts 52 and the third common routing part 53 can form a U-shaped pattern surrounding the first data part 31.

In a possible implementation mode, referring to FIGS. 2A - 2K, FIGS. 3A - 3K, FIGS. 4A - 4K and FIGS. 5A - 5H, the common routing line 5 and the gate line 2 are located on the same layer; the array substrate also includes: a lapping electrode 6; the common routing line 5 further includes: a fourth common routing part 54 connected to an end, away from the third common routing part 53, of the second common routing part 52; and the third common routing part 53 and the fourth common routing part 54 that are adjacent in the second direction Y are electrically connected through the lapping electrode 6.

In a possible implementation mode, referring to FIGS. 2A - 2K, FIGS. 3A - 3K, FIGS. 4A - 4K, and FIGS. 5A - 5H, the first common routing part 51, the second common routing part 52, and the third common routing part 53 that are connected to each other are arranged in each pixel row; and the first common routing parts 51, the second common routing parts 52, and the third common routing parts 53 of adjacent pixel rows are connected through the lapping electrodes 6, so that the common routing lines 5 form a dense network structure, to optimize the uniformity of the voltage of the common routing lines 5.

In a possible implementation mode, referring to FIGS. 2A - 2K, FIGS. 3A - 3K, FIGS. 4A - 4K, and FIGS. 5A - 5H, an orthographic projection of an extension line of an outer edge of the first data part 31 that is parallel to the second direction Y on the base substrate 1 has an overlapping region with the lapping electrode 6. That is, the lapping electrode 6 is relatively close to the data line 3. That is, the lapping electrode 6 is located in the region covered by the black matrix as much as possible, to avoid the arrangement of the lapping electrode 6 from affecting the aperture ratio of the display panel.

In a possible implementation mode, referring to FIG. 2F, the lapping electrode 6 includes: two first lapping parts 61 and a second lapping part 62 that connects two first lapping parts 61, distributed along the second direction. A width c1 of the first lapping part 61 in the first direction X is greater than a width c2 of the second lapping part 61 in the first direction X. Specifically, an orthographic projection of one of the first lapping parts 61 on the base substrate 1 can have an overlapping region with an orthographic projection of the third common routing part 53 on the base substrate 1, so that the two can be electrically connected through a first via hole K1; and an orthographic projection of the other first lapping part 61 on the base substrate 1 can have an overlapping region with an orthographic projection of the fourth common routing part 54 on the base substrate 1, so that the two can be electrically connected through another first via hole K1. Specifically, the orthographic projection of the third common routing part 53 on the base substrate 1 can overlap with the orthographic projection of the second data part 32 on the base substrate 1, and the orthographic projection of the fourth common routing part 54 on the base substrate 1 may not overlap with the orthographic projection of the second data part 32 on the base substrate 1. The orthographic projection of the second lapping electrode 62 on the base substrate 1 has an overlapping region with the orthographic projection of the gate line 2 on the base substrate 1. A width c1 of the first lapping part 61 in the first direction X is greater than a width of the second lapping part 61 in the first direction X. In this way, by making the second lapping part 62 relatively narrow, a large overlapping capacitance with the gate line 2 can be avoided, which would otherwise affect the signal transmission of the gate line 2.

In a possible implementation mode, referring to FIGS. 2A - 2K, FIGS. 3A - 3K, FIGS. 4A - 4K, and FIGS. 5A - 5H, the array substrate also includes: a plurality of transistors T. The pixel electrode 4 is electrically connected to the gate line 2 and the data line 3 through the transistor T. The orthographic projection of the lapping electrode 6 on the base substrate 1 and an orthographic projection of the transistor T on the base substrate 1 are respectively located on different sides of the data line 3. This avoids adverse effects on the transistor T when the lapping electrode 6 and the transistor T are on the same side of the data line 3 and the third common routing part 53 is electrically connected through the lapping electrode 6.

In a possible implementation mode, referring to FIGS. 2A - 2K, FIGS. 3A - 3K, FIGS. 4A - 4K, and FIGS. 5A - 5H, two adjacent lapping electrodes 6 along the second direction Y are respectively located on different sides of the data line 3.

In a possible implementation mode, referring to FIGS. 2A - 2K, FIGS. 3A - 3K, FIGS. 4A - 4K, and FIGS. 5A - 5H, the lapping electrode 6 and the pixel electrode 4 are located on the same layer. In this way, the lapping electrode 6 can be formed while the pixel electrode 4 is formed, thereby simplifying the manufacturing process of the display panel.

In a possible implementation mode, referring to FIGS. 2A - 2K and FIGS. 3A - 3K, the pixel electrode 4 is block-shaped. The display panel may also include an alignment film layer. The alignment film layer includes a plurality of alignment parts corresponding to the pixel electrodes 4 one by one. Referring to FIG. 2L, FIG. 2L shows the alignment part F corresponding to one of the pixel electrodes 4 in FIG. 2A. The alignment part F has two alignment region groups F1 distributed along the second direction Y. The alignment region group F1 includes two sub-alignment regions F11 distributed along the first direction X. The plurality of sub-alignment regions F11 are distributed in a square grid pattern, and alignment directions of different sub-alignment regions F11 are different. The orthographic projection of the first common routing part 51 on the base substrate 1 at least partially overlaps with an orthographic projection of a gap between two sub-pixel region groups F1 on the base substrate 1. Specifically, a position of dark stripes generated corresponding to the alignment part F can be seen in FIG. 2K, that is, including the horizontal dark stripe passing through a central region of the orthographic projection of the pixel electrode 4 on the base substrate 1. In a possible implementation mode, referring to FIGS. 2A - 2K and FIGS. 3A - 3K, the first common routing part 51 extends along the first direction X and passes through a central region of the orthographic projection of the pixel electrode 4 on the base substrate 1. That is, by arranging the first common routing part 51 at the position of the existing horizontal dark stripe shown in FIG. 2K, new dark stripes on the display panel caused by the arrangement of the first common routing part 51 at other positions can be avoided, which would otherwise affect the aperture ratio of the display panel. Optionally, when the pixel electrode has a slit structure, an alignment direction of the alignment part can be the same as an extension direction of the slit of the pixel electrode.

It should be noted that the pixel electrodes included in FIG. 3A and FIG. 2A in the application may also have a first slit and a second slit structure (not shown in the figure), with specific reference to FIG. 4A, which is not limited here.

In a possible implementation mode, referring to FIGS. 4A - 4K and FIGS. 5A - 5H, the pixel electrode 4 includes: a plurality of sub-pixel electrode parts P0 distributed in sequence along the first direction X; and the sub-pixel electrode part P0 has a first slit structure S1. In this way, in addition to a vertical electric field formed by the pixel electrode of the array substrate and the common electrode of the opposite substrate, the display panel also includes a horizontal electric field formed by the first slit structure S1 of the sub-pixel electrode part P0, which can make the liquid crystals have more deflection directions and improve the color shift problem of the display panel with the triple gate pixel driving structure.

Specifically, referring to FIGS. 4A - 4K and FIGS. 5A - 5H, the plurality of sub-pixel electrode parts P0 include: a first sub-pixel electrode part P1, a second sub-pixel electrode part P2, a third sub-pixel electrode part P3, and a fourth sub-pixel electrode part P4 that are distributed in sequence along the first direction X. An extension direction of the first slit structure S1 of the first sub-pixel electrode part P1 is the same as an extension direction of the first slit structure S1 of the third sub-pixel electrode part P3. An extension direction of the first slit structure S1 of the second sub-pixel electrode part P2 is the same as an extension direction of the first slit structure S1 of the fourth sub-pixel electrode part P4.

Specifically, for the display panel shown in FIGS. 4A - 4K and FIGS. 5A - 5H, dark stripes generated in a region corresponding to one pixel electrode 4 can be as shown in FIG. 4K.

In a possible implementation mode, referring to FIGS. 4A - 4K, the orthographic projection of the first common routing part 51 on the base substrate 1 overlaps with an orthographic projection of an edge region where two first edges A1 of the pixel electrode 4 are located on the base substrate 1, and the first common routing part 51 and the second common routing part 52 form a closed ring-shaped pattern. In the embodiments of the present disclosure, when the pixel electrode 4 has the dark stripe region shown in FIG. 4K by setting a plurality of sub-pixel electrode parts P0 distributed in sequence along the first direction X, by setting the first common routing part 51 in the edge region where two first edges A1 of the pixel electrode 4 are located, the problem that if the first common routing part 51 is set to extend along the first direction X and pass through a central region of the pixel electrode 4, the display panel may have horizontal dark stripes in a center of the pixel electrode 4 due to the wiring of the first common routing part 51 in addition to dark stripes caused by the domain phase distribution, resulting in a reduction in the aperture ratio of the display panel, can be avoided.

In a possible implementation mode, referring to FIGS. 5A - 5H, the orthographic projection of the first common routing part 51 on the base substrate 1 overlaps with an orthographic projection of an edge region where one of the first edges A1 of the pixel electrode 4 is located on the base substrate 1, and the first common routing part 51 and the second common routing part 52 form a U-shaped pattern with one side opening. Specifically, for example, referring to FIGS. 5A and 5B, the orthographic projection of the first common routing part 51 on the base substrate 1 overlaps with an orthographic projection of an edge region where the first edge A1 at the bottom of the pixel electrode 4 is located on the base substrate 1, and the first common routing part 51 and the second common routing part 52 form a U-shaped pattern with one side opening. In the embodiments of the present disclosure, when the pixel electrode 4 has the dark stripe region shown in FIG. 4K by setting a plurality of sub-pixel electrode parts P0 distributed in sequence along the first direction X, by setting the first common routing part 51 in the edge region where the first edge A1 of the pixel electrode 4 is located, the problem that if the first common routing part 51 is set to extend along the first direction X and pass through a central region of the pixel electrode 4, the display panel may have horizontal dark stripes in a center of the pixel electrode 4 due to the wiring of the first common routing part 51 in addition to dark stripes caused by the domain phase distribution, resulting in a reduction in the aperture ratio of the display panel, can be avoided. Moreover, compared with a situation where the orthographic projection of the first common routing part 51 on the base substrate 1 overlaps with orthographic projections of the edge regions where two first edges A1 of the pixel electrode 4 are located on the base substrate 1, in the embodiments of the present disclosure, the orthographic projection of the first common routing part 51 on the base substrate 1 overlaps with an orthographic projection of the edge region where one of the first edges A1 of the pixel electrode 4 is located on the base substrate 1, which can have a higher aperture ratio.

In a possible implementation mode, referring to FIGS. 5A - 5H, a direction of an opening of a pattern enclosed by two second common routing parts 52 and the third common routing part 53 are the same as a direction of an opening of a pattern enclosed by the first common routing part 51 and second common routing parts 52 on both sides of the first common routing part 51. Specifically, for example, referring to FIG. 5B, an opening W1 of the pattern enclosed by two second common routing parts 52 and the third common routing part 53 faces upward, an opening W2 of the pattern enclosed by the first common routing part 51 and second common routing parts 52 on both sides of the first common routing part 51 also faces upward, and their opening directions are the same.

In a possible implementation mode, referring to FIG. 5A, the pixel electrode 4 has a first side B1 opposite to the gate line 2 on one side and a second side B2 opposite to the gate line 2 on the other side. The first side B1 and the opening of the first common routing part 51 are on the same side. A minimum distance e1 between the first side B1 of the pixel electrode 4 and the adjacent gate line 2 is smaller than a minimum distance e2 between the second side B2 and the adjacent gate line 2. That is, for a side of the pixel electrode 4 on which the first common routing part 51 is not arranged, the pixel electrode 4 can be made closer to the gate line 2 on this side, to reduce the signal interference of the gate line 2 on the pixel electrode 4, and improve the problem that the liquid crystal is disordered at the edge due to the signal interference of the gate line 2 on the pixel electrode 4, resulting in dark stripes that need to be blocked by the black matrix and thus leading to a low aperture ratio. In the embodiments of the present disclosure, for the side of the pixel electrode 4 on which the first common routing part 51 is not arranged, making the pixel electrode 4 closer to the gate line 2 on this side can narrow a width of the black matrix here and increase the aperture ratio.

In a possible implementation mode, referring to FIGS. 4A - 4K and FIGS. 5A - 5H, the pixel electrode 4 also includes: a second slit structure S2 that is located between adjacent sub-pixel electrode parts and extends along the second direction Y. Specifically, the second slit structure S2 is not connected to the first slit structure S1. By setting the second slit structure S2, the problem of dark stripes of display pixels can be improved.

In a possible implementation mode, referring to FIGS. 3A - 3K, the orthographic projection of the pixel electrode 4 on the base substrate 1 at least covers an orthographic projection of part of the gate line 2 on the base substrate 1. In the embodiments of the present disclosure, the orthographic projection of the pixel electrode 4 on the base substrate 1 at least covers the orthographic projection of part of the gate line 2 on the base substrate 1. The pixel electrode 4 can shield the signal interference of the gate line 2 on the pixel electrode 4, to improve the problem that the liquid crystal is disordered at the edge due to the signal interference of the gate line 2 on the pixel electrode 4, resulting in dark stripes that need to be blocked by the black matrix and thus leading to a low aperture ratio. In the embodiments of the present disclosure, the orthographic projection of the pixel electrode 4 on the base substrate 1 at least covers the orthographic projection of part of the gate line 2 on the base substrate 1. As shown in FIG. 3H, the black matrix may not be arranged in a horizontal region where the gate line 2 is located, to increase the aperture ratio. The black matrix layer may only include the vertical black matrix shielding part 8.

Specifically, the distance by which the orthographic projections of the pixel electrodes 4 on the base substrate 1 covers the orthographic projection of the gate line 2 on the base substrate 1 should be slightly larger than an overlay distance between the pixel electrode 4 and the metal of the gate line layer. Between the pixel electrodes 4 of the two sub-pixels above the gate line 2, at least the minimum process spacing that prevents short circuits of the metal on the same layer should be reserved.

In a possible implementation mode, referring to FIGS. 3I - 3J, the display substrate also includes: a first insulating layer 12 located between the data line 3 and the pixel electrode 4. Specifically, the first insulating layer 12 can be an organic insulating layer. In the embodiments of the present disclosure, for the organic insulating layer located between the data line 3 and the pixel electrode 4, since the organic insulating layer is generally relatively thick, when the pixel electrode 4 at least covers the orthographic projection of part of the gate line 2 on the base substrate 1, a capacitance generated when the pixel electrode 4 and the gate line 2 overlap can be reduced through the relatively thick organic insulating layer, improving the influence on the signal transmission of the gate line 2 when the pixel electrode 4 and the gate line 2 overlap.

In a possible implementation mode, referring to FIGS. 2A - 2K, FIGS. 3A - 3K, FIGS. 4A - 4K, and FIGS. 5A - 5H, a width of the first data part 31 in the first direction X is greater than a width of the second data part 32 in the first direction X. For example, as shown in FIG. 2D, the width f1 of the first data part 31 in the first direction X is greater than the width f2 of the second data part 32 in the first direction X. That is, in a region where the third common routing part 53 and the data line 3 overlap, the data line 3 is made narrower to avoid affecting the signal transmission of the data line 3 when a large overlapping capacitance is generated between the third common routing part 53 and the data line 3.

In a possible implementation mode, referring to FIG. 1, the plurality of pixel electrodes 4 include: a plurality of pixel rows extending along the first direction X and arranged in sequence along the second direction Y, and a plurality of pixel columns arranged in sequence along the second direction and along the first direction.

The plurality of pixel electrodes include: a first type of pixel electrodes 41 that emit light of a first color, a second type of pixel electrodes 42 that emit light of a second color, and a third type of pixel electrodes 43 that emit light of a third color. Specifically, the light of a first color can be red light, the light of a second color can be green light, and the light of a third color can be blue light.

In the same pixel row, the first type of pixel electrodes 41, the second type of pixel electrodes 42, and the third type of pixel electrodes 43 are distributed in sequence.

In the same pixel column, only one of the first type of pixel electrodes 41, the second type of pixel electrodes 42, or the third type of pixel electrodes 43 is distributed.

In the same pixel row, each pixel electrode 4 is electrically connected to the same gate line 2 through the transistor T. In the same pixel column, two adjacent pixel electrodes 4 are alternately electrically connected to different data lines 3 on both sides of the pixel electrodes 4 through the transistors T.

In a possible implementation mode, a layer where the data line 3 is located can be on a side, away from the base substrate 1, of a layer where the gate line 2 is located; and a layer where the pixel electrode 4 is located can be on a side, away from a layer where the gate line 2 is located, of a layer where the data line 3 is located. An active layer can also be arranged between the layer where the data line 3 is located and the layer where the gate line 2 is located, and the active layer can include an active pattern 91 (as shown in FIG. 2C). Specifically, referring to FIGS. 2I, 2J, 3I, 3J, 4I and 4J, a gate insulating layer 11 can also be arranged between the layer where the gate line 2 is located and the active layer. Specifically, a first insulating layer 12 can also be arranged between the layer where the data line 3 is located and the layer where the pixel electrode 4 is located. Specifically, the first insulating layer 12 can be an organic insulating layer. Specifically, the first insulating layer 12 can also be an inorganic insulating layer.

Based on the same inventive concept, embodiments in the present disclosure also provide a display panel, which includes the array substrate according to the embodiments of the present disclosure and also includes an opposite substrate arranged opposite to the array substrate. The opposite substrate is provided with a common electrode layer, and a signal loaded on the common routing line 5 is the same as a signal loaded on the common electrode layer.

In a possible implementation mode, referring to FIGS. 2A - 2K and FIGS. 3A - 3K, the opposite substrate is also provided with a spacer 7, and an orthographic projection of the first data part 31 on the base substrate covers an orthographic projection of the spacer 7 on the base substrate 1.

In a possible implementation mode, referring to FIGS. 2A - 2K and FIGS. 3A - 3K, the first data part 31 has an overlapping part and an extension part located on a periphery of the overlapping part. An orthographic projection of the overlapping part on the base substrate overlaps with an orthographic projection of the spacer 7 on the base substrate, and an orthographic projection of the extension part on the base substrate 1 does not overlap with the orthographic projection of the spacer 7 on the base substrate 1. In the embodiments of the present disclosure, the spacer 7 is placed on the data line 3, and a corresponding position of the data line 3 needs to be widened to form a metal cushion layer to prevent the spacer 7 from slipping. Here, the metal cushion layer (that is, the first data part 31) surrounds and wraps the spacer 7, and it is ensured that a size of each of its four sides is at least larger than a size of the spacer 7 by a distance equivalent to the alignment accuracy. Specifically, in the embodiments of the present disclosure, the organic insulating layer may not be arranged.

Specifically, in the embodiments of the present disclosure, the spacer 7 is also surrounded by the second common routing part 52 and the third common routing part 54 on its periphery, which can also prevent the spacer 7 from sliding into the pixel region.

Specifically, the spacer 7 can be located on the opposite substrate or can also be arranged on the array substrate.

In a possible implementation mode, referring to FIGS. 4A - 4K and FIGS. 5A - 5H, the opposite substrate is also provided with a spacer 7. An orthographic projection of the spacer 7 on the base substrate 1 is located on a side of an orthographic projection of the second data part 32 on the base substrate 1, and the orthographic projection of the spacer 7 on the base substrate 1 has an overlapping region with an orthographic projection of the lapping electrode 6 on the base substrate 1. Specifically, when the organic insulating layer is arranged, the spacer 7 may not be arranged on the data line 3, and its position can be flexibly set, but it should avoid being arranged in a region where the transistor is located, to avoid affecting the transistor.

In a possible implementation mode, referring to FIGS. 4A - 4K and FIGS. 5A - 5H, the orthographic projection of the spacer 7 on the base substrate 1 and the orthographic projection of the transistor T on the base substrate 1 are respectively located on different sides of the data line 3. In this way, it can avoid being arranged in a region where the transistor is located, to avoid affecting the transistor.

In a possible implementation mode, at least one of the array substrate or the opposite substrate is provided with an alignment film layer. The alignment film layer includes a pixel alignment region corresponding to the pixel electrode 4, the pixel alignment region includes four sub-alignment regions, and alignment directions of at least two sub-alignment regions are different.

In a possible implementation mode, the opposite substrate can be provided with a black matrix layer, and the black matrix layer can include a black matrix shielding part 8 and a black matrix opening.

Based on the same inventive concept, embodiments of the present disclosure also provide a display apparatus, which includes the display panel according to the embodiments of the present disclosure.

Based on the same inventive concept, embodiments of the present disclosure also provide a display apparatus including the above-mentioned display panel according to the embodiments of the present disclosure. For the implementation of the display apparatus, reference can be made to the embodiments of the above-mentioned display panel, and repeated content will not be elaborated here.

During specific implementation, in embodiments of the present disclosure, the display apparatus can be: a mobile phone, a tablet computer, a television, a monitor, a laptop computer, a digital photo frame, a navigator, or any other products or components with display functions. Other essential components of the display apparatus should be understood by those of ordinary skill in the art, and are not described herein, nor should they be taken as limitations on the present disclosure.

Although the preferred embodiments of the present disclosure have been described, those skilled in the art can make additional changes and modifications to these embodiments once they learn the basic creative concepts. Therefore, the appended claims are intended to be interpreted as including the preferred embodiments as well as all changes and modifications falling within the scope of the present disclosure.

Obviously, those skilled in the art can make various changes and variations to the present disclosure without departing from the spirit and scope of the present disclosure. Thus, if these modifications and variations of the present disclosure fall within the scope of claims of the present disclosure and their equivalent technologies, the present disclosure also intends to include these changes and variations.

## Claims

1. An array substrate, comprising:
a base substrate;
a plurality of gate lines, arranged on a side of the base substrate, wherein the plurality of gate lines extend along a first direction;
a plurality of data lines, arranged on the same side of the base substrate as the plurality of gate lines, wherein the plurality of data lines extend along a second direction;
a plurality of pixel electrodes, arranged on the same side of the base substrate as the plurality of gate lines and located in regions formed by intersections of the plurality of gate lines and the plurality of data lines; wherein the pixel electrode comprises a first edge extending along the first direction and a second edge extending along the second direction, and a length of the first edge in the first direction is greater than a length of the second edge in the second direction; and
a common routing line, arranged on the same side of the base substrate as the plurality of gate lines, wherein the common routing line comprises: a first common routing part and a second common routing part that are distributed in sequence along the first direction; wherein the first common routing part extends along the first direction, and an orthographic projection of the first common routing part on the base substrate has an overlapping region with an orthographic projection of the pixel electrode on the base substrate; the second common routing part extends along the second direction, an orthographic projection of the second common routing part on the base substrate is disposed in a periphery of a data line between adjacent pixel electrodes, and the orthographic projection of the second common routing part on the base substrate has an overlapping region with the orthographic projection of the pixel electrode on the base substrate.

2. The array substrate according to claim 1, wherein the common routing parts comprise two second common routing parts, and a third common routing part that connects ends of two second common routing parts and extends along the first direction;
the data line comprises: a first data part and a second data part that are alternately distributed along the second direction; wherein, an orthographic projection of the first data part on the base substrate is disposed between two adjacent pixel electrodes; and the third common routing part and the second data part are insulated and crossed.

3. The array substrate according to claim 2, wherein the common routing line and the plurality of gate lines are on a same layer;
the array substrate further comprises: a lapping electrode;
the common routing line further comprises: a fourth common routing part connected to an end, away from the third common routing part, of the second common routing part;
in the second direction, the third common routing part and the fourth common routing part that are adjacent are electrically connected through the lapping electrode.

4. The array substrate according to claim 3, wherein an orthographic projection of an extension line of an outer edge of the first data part that is parallel to the second direction on the base substrate has an overlapping region with the lapping electrode.

5. The array substrate according to claim 3 or 4, further comprising: a plurality of transistors, and the pixel electrode is electrically connected to the gate line and the data line through the transistor;
an orthographic projection of the lapping electrode on the base substrate and an orthographic projection of the transistor on the base substrate are respectively disposed on different sides of the data line.

6. The array substrate according to claim 5, wherein two adjacent lapping electrodes along the second direction are respectively disposed on different sides of the data line; and the lapping electrode and the pixel electrode are disposed on a same layer.

7. The array substrate according to any one of claims 1-6, wherein the first common routing part extends along the first direction and passes through a central region of the orthographic projection of the pixel electrode on the base substrate.

8. The array substrate according to any one of claims 1-6, wherein the orthographic projection of the first common routing part on the base substrate overlaps with an orthographic projection of an edge region where the first edge of the pixel electrode is located on the base substrate, and the first common routing part and the second common routing part form a U-shaped pattern with one side opening.

9. The array substrate according to claim 8, wherein a direction of an opening of a pattern enclosed by two second common routing parts and the third common routing part are the same as a direction of an opening of a pattern enclosed by the first common routing part and second common routing parts on both sides of the first common routing part.

10. The array substrate according to claim 9, wherein the pixel electrode has a first side opposite to the gate line on one side and a second side opposite to the gate line on the other side; the first side and an opening of the first common routing part are on a same side;
a minimum distance between the first side of the pixel electrode and an adjacent gate line is smaller than a minimum distance between the second side and an adjacent gate line.

11. The array substrate according to any one of claims 1-6, wherein the orthographic projection of the first common routing part on the base substrate overlaps with orthographic projections of edge regions where two first edges of the pixel electrode are located on the base substrate, and the first common routing part and the second common routing part form a closed ring-shaped pattern.

12. The array substrate according to any one of claims 8-11, wherein the pixel electrode comprises: a plurality of sub-pixel electrode parts distributed in sequence along the first direction; and the sub-pixel electrode part has a first slit structure.

13. The array substrate according to claim 12, wherein the plurality of sub-pixel electrode parts comprise: a first sub-pixel electrode part, a second sub-pixel electrode part, a third sub-pixel electrode part, and a fourth sub-pixel electrode part that are distributed in sequence along the first direction;
an extension direction of a first slit structure of the first sub-pixel electrode part is the same as an extension direction of a first slit structure of the third sub-pixel electrode part;
an extension direction of a first slit structure of the second sub-pixel electrode part is the same as an extension direction of a first slit structure of the fourth sub-pixel electrode part.

14. The array substrate according to claim 13, wherein the pixel electrode further comprises: a second slit structure that is disposed between adjacent sub-pixel electrode parts and extends along the second direction.

15. The array substrate according to claim 7 or 8, wherein the orthographic projection of the pixel electrode on the base substrate at least covers an orthographic projection of part of the gate line on the base substrate.

16. The array substrate according to claim 15, wherein the display substrate further comprises: an organic insulating layer disposed between the data line and the pixel electrode.

17. The array substrate according to any one of claims 2-16, wherein a width of the first data part in the first direction is greater than a width of the second data part in the first direction.

18. The array substrate according to any one of claims 1-17, wherein the plurality of pixel electrodes comprise: a plurality of pixel rows extending along the first direction and arranged in sequence along the second direction, and a plurality of pixel columns arranged in sequence along the second direction and along the first direction;
the plurality of pixel electrodes comprise: a first type of pixel electrode that emits light of a first color, a second type of pixel electrode that emits light of a second color, and a third type of pixel electrode that emits light of a third color;
in the same pixel row, the first type of pixel electrode, the second type of pixel electrode, and the third type of pixel electrode are distributed in sequence;
in the same pixel column, only one of the first type of pixel electrode, the second type of pixel electrode, or the third type of pixel electrode is distributed;
in the same pixel row, each of the plurality of pixel electrodes is electrically connected to a same gate line through a transistor;
in the same pixel column, two adjacent pixel electrodes are alternately electrically connected to different data lines on both sides of the pixel electrodes through transistors.

19. A display panel, comprising the array substrate according to any one of claims 1-18, and an opposite substrate opposite to the array substrate;
wherein the opposite substrate is provided with a common electrode layer, and a signal loaded on the common routing line is the same as a signal loaded on the common electrode layer.

20. The display panel according to claim 19, wherein the opposite substrate is further provided with a spacer, and an orthographic projection of a first data part on the base substrate covers an orthographic projection of the spacer on the base substrate.

21. The display panel according to claim 19, wherein the opposite substrate is also provided with a spacer, an orthographic projection of the spacer on the base substrate is disposed on a side of an orthographic projection of a second data part on the base substrate, and the orthographic projection of the spacer on the base substrate has an overlapping region with an orthographic projection of a lapping electrode on the base substrate.

22. The display panel according to claim 21, wherein the orthographic projection of the spacer on the base substrate and an orthographic projection of a transistor on the base substrate are respectively disposed on different sides of the data line.

23. The display panel according to any one of claims 19-22, wherein at least one of the array substrate or the opposite substrate is provided with an alignment film layer, the alignment film layer comprises a pixel alignment region corresponding to the pixel electrode, the pixel alignment region comprises four sub-alignment regions, and alignment directions of at least two of the sub-alignment regions are different.

24. A display apparatus, comprising the display panel according to any one of claims 19-23.
